# EUROPÄISCHE PATENTSCHRIFT

(11) **EP 1 825 711 B1**
(45) Veröffentlichungstag und Bekanntmachung des Hinweises auf die Patenterteilung: **20.06.2018**
(21) Anmeldenummer: 05816094.6
(22) Anmeldetag: 14.11.2005
(51) Int. Cl.: G01S 7/524, B06B 1/02, H03J 3/20, H03J 5/24

(54) **VORRICHTUNG UND VERFAHREN ZUR DÄMPFUNG EINES PARALLELSCHWINGKREISES**
DEVICE AND METHOD FOR ATTENUATING AN ANTI-RESONANT CIRCUIT
PROCEDE ET DISPOSITIF POUR ATTENUER UN CIRCUIT OSCILLANT PARALLELE

(30) Priorität: 06.12.2004 DE 102004058665
(43) Veröffentlichungstag der Anmeldung: 29.08.2007
(73) Patentinhaber: ROBERT BOSCH GMBH, 70442 Stuttgart (DE)
(72) Erfinder: REICHE, Martin, 74321 Bietigheim (DE)
(86) Internationale Anmeldenummer: PCT/EP2005/055939
(87) Internationale Veröffentlichungsnummer: WO 2006/061305

(56) Entgegenhaltungen:
- US-A- 5 199 299
- US-A- 5 267 219

## Beschreibung

### STAND DER TECHNIK

Die vorliegende Erfindung betrifft eine Vorrichtung und ein Verfahren zur Dämpfung eines Parallelschwingkreises.

Obwohl die vorliegende Erfindung mit Bezug auf einen Ultraschallwandler für eine Verwendung in einer Einparkhilfe beschrieben wird, ist die vorliegende Erfindung darauf nicht beschränkt.

Aus der US 5,267,219 ist ein akustisches Abstandsmesssystem bekannt, bei dem ein piezoelektrischer Transducer über einen Transformator mit einem Empfangsverstärker verbunden ist. Ein Transistor kann über eine Recheneinheit derart angesteuert werden, dass ein ohmsches Dämpfungsglied parallel zu dem Eingangs des Verstärkers geschaltet wird.

Zur Bestimmung eines Abstandes eines Fahrzeuges zu einem weiteren Fahrzeug kann die Laufzeit eines Ultraschallpulses für die Distanz zu einem vorderen Fahrzeug und zurück gemessen werden. Ein Ultraschallwandler erzeugt dafür ein Ultraschallsignal in Pulsform. Ein Ultraschallsensor erfasst die reflektierten Anteile des Ultraschallsignals und eine nachgeschaltete Vorrichtung bestimmt die Laufzeit. Aus der bekannten Schallgeschwindigkeit von etwa 330 m/s und bei einem Abstand zu dem vorderen Fahrzeug von etwa 7,5 cm ergibt sich eine Laufzeit 0,5 ms.

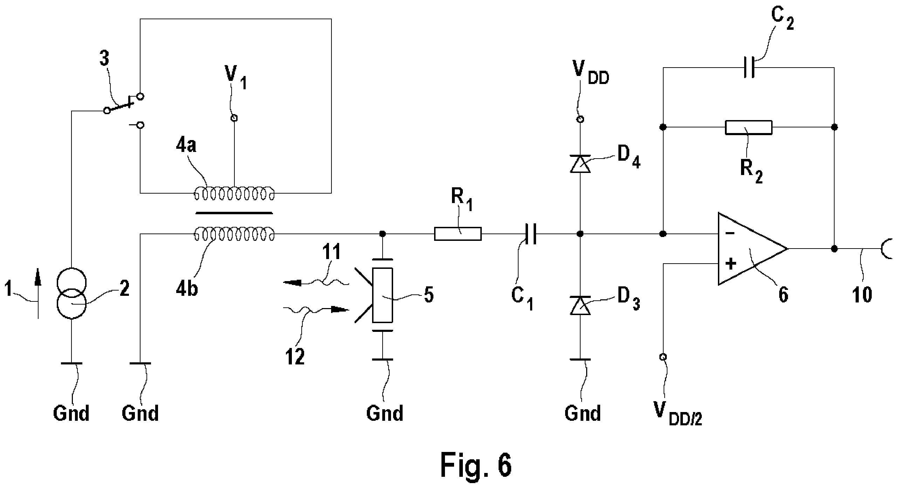

Das Ultraschallsignal wird typischerweise durch eine Schallwandlereinrichtung generiert, bei welcher ein Piezoaktuator eine Topfmembran antreibt. An einen Piezoaktuator wird ein Spannungssignal mit einer Frequenz im Ultraschallbereich (> 20 kHz) und einer Amplitude im mittleren Spannungsbereich (10 V - 200 V) angelegt. Mit Bezug auf Figur 6 ist eine elektronische Beschaltung einer solchen Schallwandlereinrichtung 5 dargestellt. Eine Stromquelle 2 generiert einen Sendestrom 1 (Signal), welcher induktiv über eine primäre Induktivität 4a einer Übertragereinrichtung 4 in eine sekundäre Induktivität 4b übertragen wird. Dabei wird der Sendestrom 1 durch den Schalter 3 umgetastet, welcher nach einer Sendeanregung in eine hochohmige Mittellage übergeht. Die sekundäre Induktivität 4b bildet zusammen mit der Schallwandlereinrichtung und deren elektrischer Kapazität einen Parallelschwingkreis mit einer elektrischen Resonanzfrequenz. Die elektrische Resonanzfrequenz liegt im Ultraschallbereich. Um eine optimale Anregung des Piezoaktuators zu erreichen, ist die elektrische Resonanzfrequenz auf die mechanische Resonanzfrequenz der Schallwandlereinrichtung 5 abgestimmt.

Die Schallwandlereinrichtung 5 wird nicht nur zum Senden des akustischen Ultraschallsignals 11 verwendet, sondern auch zum Empfangen des reflektierten Anteils 12 des Ultraschallsignals 11. Das empfangene reflektierte Ultraschallsignal 12 wird durch die Schallwandlereinrichtung 5 in einen Spannungspegel gewandelt und über eine Verstärkereinrichtung mit einem Operationsverstärker 6 verstärkt und als Ausgangsignal 10 ausgegeben.

Der Anteil des reflektierten Ultraschallsignals 12 des gesendeten Ultraschallsignals 11 ist sehr gering. Entsprechend ergeben sich nur sehr geringe Spannungspegel bei der Wandlung des reflektierten Ultraschallssignals durch die Schallwandlereinrichtung. Diese liegen typischerweise im Bereich von wenigen 10 µV am Verstärkereingang. Um diese Signale erfassen zu können, ist es notwendig, dass die Spannungsamplitude der Oszillation in dem Parallelschwingkreis während des Aussendens des Ultraschallpulses 11 auf ein geringeres Niveau als das Spannungspotential der empfangenen Signale abgesunken ist. Um dies zu erreichen, ist eine ausreichend starke Dämpfung des Parallelschwingkreises notwendig. Eine Dämpfung erfolgt über einen Widerstand R₁, welcher mit dem invertierenden Eingang des Operationsverstärkers verbunden ist. Solange der Operationsverstärker 6 durch die Signalamplitude des Parallelschwingkreises nicht in Sättigungen getrieben wird, ergibt sich eine Dämpfung des Parallelschwingkreises, welche proportional dem Widerstand R₁ und der Spannungsamplitude der Oszillation in dem Parallelschwingkreis ist, dadurch dass ein Strom in die virtuelle Masse an dem invertierenden Eingang des Operationsverstärkers 6 fließt. Bei einer typischen Verstärkung der rückgekoppelten Operationsverstärkerschaltung von 10, Versorgungsspannungen des Operationsverstärker von 0 und 5 Volt und einer Vorspannung gleich der halben Versorgungsspannung (2,5 V) am nichtinvertierenden Eingang des Operationsverstärkers, erfolgt spätestens bei einem Signal mit einer Amplitude von 250 mV eine Sättigung des Operationsverstärkers. Die Sättigung tritt entsprechend früher ein, wenn der maximale Aussteuerpegel des Operationsverstärkers geringer als die Versorgungsspannung ist.

Typischerweise ist ein invertierender Eingang des Operationsverstärkers 6 über Schutzdioden D₃ und D₄ mit einem Massepotential Gnd bzw. V_{DD} in Sperrrichtung verbunden. Außerdem ist der Parallelschwingkreis über eine Kapazität C₁ mit dem Operationsverstärker verbunden, um eine Trennung der Gleichspannungspegel zu erreichen. Für Signalamplituden des Parallelschwingkreises deren Betrag größer ist als die Summe aus der halben Versorgungsspannung V_{DD/2} (2,5 V) und dem Spannungsabfall über den Dioden D₃ und D₄ (0,6 V), ergibt sich ein Stromfluss zu dem Versorgungspotential V_{DD} bzw. dem Massepotential Gnd über den Widerstand R₁. Auf diese Weise ergibt sich für große Amplituden, in dem zuvor gewählten Beispiel für Amplituden mit einem Betrag von 3,1 V, eine Dämpfung des Parallelschwingkreises, welche proportional der Amplitude des Signals in dem Parallelschwingkreis und proportional zu dem Widerstand R₁ ist. Für Signalamplituden in dem Bereich zwischen 0,25 V und 3,1 V ergibt sich jedoch keine Dämpfung, welche linear von der Signalamplitude in dem Parallelschwingkreis abhängt, weil einerseits die Klemmdioden noch nicht leiten, andererseits der Operationsverstärker in Sättigung ist..

Statt einer Klemmung des invertierenden Eingangs des Operationsverstärkers mit Dioden, kann ein Transistorpaar zweier Leitfähigkeitstypen in Push-Pull-Konfiguration verwendet werden. Dabei verbindet der Emitter-Kollektor-Pfad des einen Transistors die Masse mit dem invertierenden Eingang und der Emitter-Kollektor-Pfad des anderen Transistors die Versorgungsspannung mit dem invertierenden Eingang. An der Basis der Transistoren liegt die halbe Versorgungsspannung an. Dadurch schaltet einer der beiden Transistoren leitend, wenn der Betrag der Signalamplitude größer als 0,6 V wird. Es ergibt sich hierbei ein nicht-linear gedämpfter Bereich von 0,25 V bis 0,6 V.

### VORTEILE DER ERFINDUNG

Eine Idee der vorliegenden Erfindung, ist eine Vorrichtung zur Dämpfung eines Parallelschwingkreises mit einer sekundären Induktivität und einer ersten Kapazität bereitzustellen, wobei in die sekundäre Induktivität über eine primäre Induktivität ein Signal induktiv einkoppelbar ist. Dabei ist der sekundären Induktivität des Übertragers ein Dämpfungsglied mit einer Schalteinrichtung parallel geschaltet. Ferner kann ein Kondensator den Parallelschwingkreis mit dem invertierenden Eingang des Operationsverstärkers verbinden. Dies ermöglicht eine Gleichsignalentkopplung zwischen dem Operationsverstärker und dem Parallelschwingkreis. Weiterhin ist in der Schalteinrichtung ein erster Transistor zwischen dem Verknüpfungspunkt und einem ersten Potential angeordnet und ein zweiter Transistor zwischen dem Verknüpfungspunkt und einem ersten Massepotential angeordnet. Zudem sind die Steuereingänge der beiden Transistoren mit einem Signalausgang des Operationsverstärkers verbunden. Vorteilhafterweise steuert auf diese Weise das Ausgangssignal des Operationsverstärkers, welches durch eine Verstärkung des Signals gebildet wird, das an der Basis der Transistoren anliegende Potential. Einer der beiden Transistoren wird leitend, wenn das Eingangssignal mal die effektive Verstärkung der Operationsverstärkerschaltung grösser als die Schwellspannung einer der beiden Transistoren ist. Auf diese Weise kann eine Bedämpfung über das Dämpfungsglied für kleine Signalamplituden erreicht werden.

Ein Vorteil der vorliegenden Erfindung ist, dass eine linear von der Signalamplitude abhängige Bedämpfung über den gesamten Spannungsbereich einer Signalamplitude erreicht wird.

Ein erfindungsgemäßes Verfahren sieht vor, die Schalteinrichtung in einen leitfähigen Zustand zu schalten, wenn das Signal gedämpft werden soll.

Ein Vorteil des erfindungsgemäßen Verfahrens ist, dass zu einem vorgegebenen Zeitpunkt eine Dämpfung einsetzt, indem die Schalteinrichtung in einen schaltenden Zustand geschalten wird und zu anderen Zeitpunkten der Parallelschwingkreis nicht gedämpft ist. Dies ist insbesondere für eine Schallwandlereinrichtung vorteilhaft, welche mit maximaler Amplitude emittiert, dann gedämpft wird, um einen schnellen Abfall der Signalamplitude zu erreichen und danach für einen Empfang eines reflektierten Schallsignals zum Empfangen bereitsteht.

In den Unteransprüchen finden sich vorteilhafte Weiterbildungen und Verbesserungen der im Patentanspruch 1 angegeben Vorrichtung zum Dämpfen eines Parallelschwingkreises, sowie des im Patentanspruch 12 angegebenen Verfahrens zum Dämpfen eines Parallelschwingkreises.

Gemäß einer bevorzugten Weiterbildung ist die primäre Induktivität mit einer Stromquelle über ein Schaltelement verbunden. Vorteilhafterweise kann somit zusätzlich zu einer Dämpfung des Parallelschwingkreises die Stromquelle abgekoppelt werden. Während des Empfangs von Signalen durch die Schallwandlereinrichtung wird standardmäßig die Stromquelle abgekoppelt.

Gemäß einer weiteren Weiterbildung ist ein Verknüpfungspunkt zwischen dem Parallelschwingkreis und der Schalteinrichtung mit einem invertierenden Eingang eines Operationsverstärkers verbunden. Reflektierte Ultraschallsignale, welche in die Schallwandlereinrichtung einkoppeln, können somit einer Verstärkungseinrichtung zugeführt werden.

Gemäß einer weiteren Weiterbildung ist zwischen Steuereingängen der beiden Transistoren und dem Signalausgang des Operationsverstärkers eine Schalteinrichtung angeordnet. Dies ermöglicht die Dämpfung des Signals ein- bzw. auszuschalten.

Gemäß einer weiteren Weiterbildung ist zwischen den Steuereingängen der beiden Transistoren und dem Signalausgang des Operationsverstärkers ein Spannungsteiler angeordnet. Dieser ermöglicht eine Anpassung des minimalen Spannungspegels, für den eine Dämpfung einsetzen soll, unabhängig von der Verstärkung der Operationsverstärkerschaltung.

Eine erfindungsgemäße Vorrichtung zur Dämpfung eines Parallelschwingkreises mit einer sekundären Induktivität und einer ersten Kapazität, wobei in die sekundäre Induktivität über primäre Induktivität ein Signal induktiv einkoppelbar ist, weist ein Dämpfungsglied mit einer passiven Schalteinrichtung auf, welches parallel zu der sekundären Induktivität geschaltet ist. Vorteilhafterweise wird für Signale, welche die Schwellspannung der Dioden überschreiten eine Dämpfung erreicht. Bei einer vorteilhaften Verwendung von Schottkydioden kann somit eine Bedämpfung ab 0,2 V erreicht werden.

Gemäß einer weiteren Weiterbildung ist ein Verknüpfungspunkt zwischen dem Dämpfungsglied und der passiven Schalteinrichtung mit dem Koppelkondensator und damit DC Potential GND verbundenverbunden. Dies ist das DC-Potential der Schallwandlereinrichtung 5. Die Bedämpfung erfolgt somit gegen ein niederohmiges Potential GND mit vernachlässigbarem Innenwiderstand, statt gegen ein Referenzpotentialdes OP mit nicht vernachlässigbarem Innenwiderstand (V_dd/2) und möglichen Koppeleffekten in weiteren Teilen der Beschaltung (V_dd/2 wird verzogen, Mitschwingen weiterer Verstärkerstufen mit gleichem Ref-Potential).

### ZEICHNUNGEN

Ausführungsbeispiele der Erfindung, sowie vorteilhafte Weiterbildungen sind in den Figuren der Zeichnungen dargestellt und in der nachfolgenden Beschreibung näher erläutert.

In den Figuren zeigen:
Figur 1 eine schematische Darstellung einer ersten beispielhaften Ausführungsform;
Figur 2 eine schematische Darstellung einer zweiten Ausführungsform;
Figur 3 eine Ausführungsform der vorliegenden Erfindung;
Figur 4 eine schematische Darstellung einer Schalteinrichtung für die gezeigten Ausführungsformen;
Figur 5 eine dritte beispielhafte Ausführungsform;
und Figur 6 eine schematische Darstellung zur Erläuterung der vorliegenden Problematik.

### BESCHREIBUNG DER AUSFÜHRUNGSBEISPIELE

In den Figuren bezeichnen gleiche Bezugszeichen gleiche oder funktionsgleiche Komponenten, soweit nichts gegenteiliges angegeben ist.

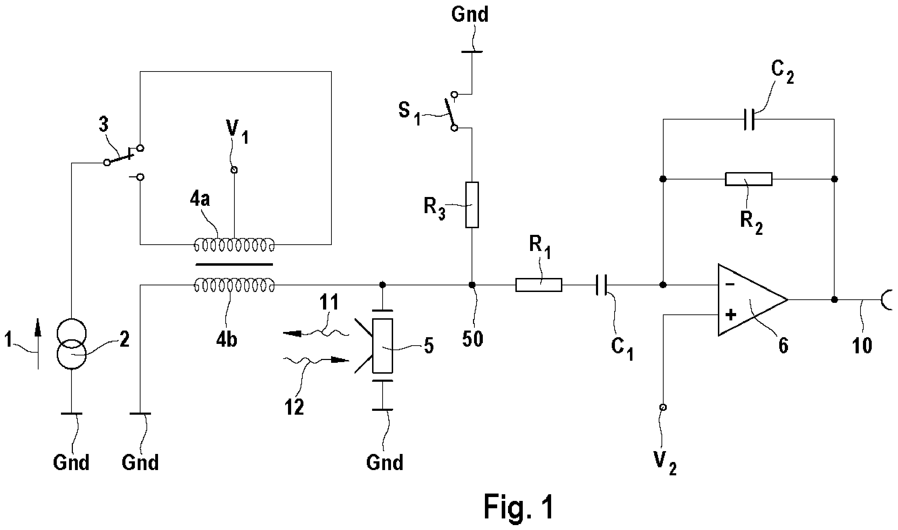

In Figur 1 ist eine schematische Darstellung einer ersten beispielhaften Ausführungsform dargestellt. Eine Schallwandlungseinrichtung 5 dient zum Senden von Ultraschallsignalen 11 und zum Empfangen von reflektierten Ultraschallsignalen 12. Die Ultraschallsignale 11 werden vorzugsweise als Impulse gesendet. Durch Erfassen der Zeitspanne, welche ein gesendetes Ultraschallsignal 11 benötigt, bevor es als reflektiertes Ultraschallsignalsignal 12 empfangen wird, kann die Entfernung zu dem Objekt bestimmt werden, an welchem das Ultraschallsignal 11 reflektiert wurde. Dies kann unter anderem in Einparkhilfen für Fahrzeuge verwendet werden. Aufgrund der Schallgeschwindigkeit von etwa 330 m/s ergibt sich eine Laufzeit von etwa einer ms für eine Distanz von 15 cm der Schallwandlereinrichtung zu dem Objekt.

Die Schallwandlereinrichtung 5 kann durch eine Topfmembran gebildet werden, welche durch einen Piezoaktuator bewegt wird. Der Piezoaktuator entspricht in einer guten Näherung in einem elektrischen Ersatzschaltbild einem Kondensator. Die mechanischen Eigenschaften der Topfmembran wie deren, Steifigkeit, Masse und mechanische Bedämpfung bestimmen die Resonanzfrequenz und das Abklingverhalten der Schallwandlereinrichtung. Deren Verhalten kann in dem Ersatzschaltbild als ein zu dem Kondensator parallel geschalteter Serienschaltkreis aus einem Widerstand, einem Kondensator und einer Induktivität modelliert wurden.

Die Schallwandlereinrichtung 5 wird einer sekundären Induktivität 4b parallel geschaltet. Die Induktivität 4b und die Kapazität 5 der Schallwandlereinrichtung 5 bilden auf diese Weise einen Parallelschwingkreis. Vorzugsweise wird die Eigenresonanz dieses Parallelschwingkreises so angepasst, dass sie der mechanischen Eigenresonanz der Schallwandlereinrichtung 5 entspricht. Auf diese Weise wird eine maximale Auslenkungsamplitude der Topfmembran erreicht und somit ein maximaler Schalldruck erzeugt. Dabei ist zu beachten, dass die Schallwandlereinrichtung 5 derart aufgebaut ist, dass deren Eigenresonanzen im Ultraschallbereich liegen.

In die sekundäre Induktivität 4b wird über eine primäre Induktivität 4a ein Signal 1 eingekoppelt. Die sekundäre und primäre Induktivität können zusammen einen Übertrager 4 bilden. Dies ermöglicht eine Spannungsüberhöhung des eingekoppelten Signal 1 von der Primärseite auf die Sekundärseite des Transformators 4. Das Signal 1 wird durch eine Stromquelle 2 bereitgestellt, welches über ein Schaltelement 3, z.B. einem Wechselschalter, mit der primären Induktivität 4a verbunden werden kann.

Um die Laufzeit des Ultraschallsignals 11 zu messen, ist es erforderlich, dass das reflektierte Ultraschallsignal 12 erfasst werden kann. Die Schallwandlereinrichtung 5 wandelt das reflektierte Ultraschallsignal 12 in ein Spannungssignal um. Da jedoch nur ein geringer Anteil des gesendeten Ultraschallsignals 11 reflektiert wird, ist das entsprechende Spannungssignal sehr gering. Eine typische Größenordnung dieser Spannungssignale liegt im Bereich von wenigen µV. Die Signalamplitude in dem Parallelschwingkreis, welche zur Anregung der Topfmembran verwendet wird, liegt hingegen im Bereich von 10 V - 200 V oder größer. Daraus folgt, dass es möglich sein muss, die Spannungsamplitude in dem Parallelschwingkreis aus der sekundären Induktivität 4b und der Schallwandlereinrichtung 5 auf einen Spannungspegel zu dämpfen, welcher geringer als einige µV ist. Somit ist eine Dämpfung von mehr als 140 dB nötig. Die Zeitspanne, innerhalb welcher die Dämpfung erreicht werden muss, ist durch die Laufzeit des Ultraschallsignals 11 zu dem reflektierenden Objekt und zurück zu der Schallwandlereinrichtung 5 gegeben, typischerweise im Bereich von etwa 1 ms, gemäß einer Nahmessfähigkeit von 20cm.

Eine rein mechanische Dämpfung der Topfmembran, um entsprechende Abklingzeiten zu ereichen ist nicht erwünscht, das dies einem hohen Sende-Schalldruck der Signalwandlereinrichtung 5 entgegensteht. Zudem würde diese Dämpfung permanent wirken und auch die reflektierten Ultraschallsignale 12 durch die mechanische Dämpfung abgeschwächt. In der ersten Ausführungsform ist vorgesehen, den elektrischen Parallelschwingkreis aus der sekundären Induktivität 4b und der Kapazität der Schallwandlereinrichtung 5 durch Dämpfungsglieder R₁ und R₃ zu dämpfen. Diese beiden Dämpfungsglieder R₁, R₃ können Widerstände aufweisen. Das Dämpfungsglied R₃ bildet mit der Schalteinrichtung S₁ eine Serienschaltung, welche parallel zu der sekundären Induktivität 4b geschaltet ist. In der Darstellung in Figur 1 erfolgt die Parallelschaltung über das Massepotential Gnd. Wird die Schalteinrichtung S₁ leitend geschaltet, fließt ein Strom durch das Dämpfungsglied R₃ und eine entsprechende Leistung wird in dem Dämpfungsglied R₃ dissipiert. Mit einer geeigneten Wahl des Widerstandes des Dämpfungsgliedes R₃ kann eine Dämpfung von mehr als 140 dB innerhalb von wenigen ms erreicht werden.

Beim Empfang von Ultraschallsignalen 12 durch die Schallwandlereinrichtung 5 ist die Schalteinrichtung S₁ in sperrendem Zustand. Hierbei erfolgt ein Dämpfung des Signals allein durch den Stromfluss in die virtuelle Masse über den Widerstand R₁, welcher die Schallwandlereinrichtung 5 mit dem invertierenden Eingang des Operationsverstärkers 6 verbindet. Diese Dämpfung wird vorteilhafterweise für das Empfangen und Senden von Ultraschallsignalen gering gehalten, indem ein Dämpfungsglied R₁ mit einem hohen Widerstand verwendet wird. Somit werden die Signale nur wenig gedämpft. Auf die gleiche Weise kann ein maximaler Schalldruck des Ultraschallsignals 11 beim Senden erreicht werden.

Das Dämpfungsglied R₁ verbindet den Parallelschwingkreis aus der sekundären Induktivität 4b und der Schallwandlereinrichtung 5 mit dem invertierenden Eingang eines Operationsverstärkers 6. Der Operationsverstärker 6 ist mittels eines Widerstandes R₂ und einer Kapazität C₂ rückgekoppelt. Dies ermöglicht empfangene Ultraschallsignale 12 und deren entsprechende Spannungspegel durch die Operationsverstärkerschaltung aus dem Operationsverstärker 6, dem Dämpfungsglied R₁, welches nun als Vorwiderstand fungiert und der Rückkopplung zu verstärken und als Ausgangssignal 10 auszugeben.

Eine weitere Ausführungsform sieht vor, eine nichtinvertierende Operationsverstärkerschaltung mit einem sehr hohen Eingangswiderstand zu verwenden. Dabei ist der Eingang des Operationsverstärkers über einen Widerstand mit dem Massepotential und dem Parallelschwingkreis verbunden.

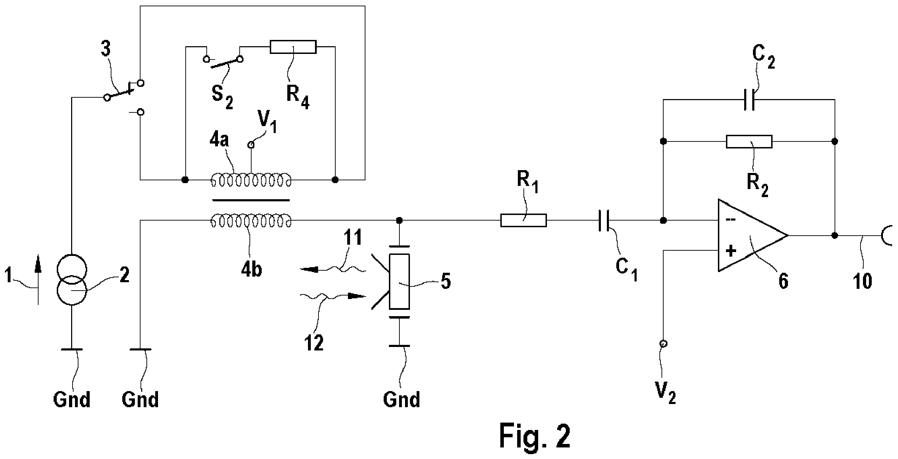

In Figur 2 ist eine zweite beispielhafte Ausführungsform dargestellt. Im Gegensatz zur ersten beispielhaften Ausführungsform wird in diesem Fall eine Serienschaltung aus einem Dämpfungsglied R₄ und einer Schalteinrichtung S₂ parallel zur primären Induktivität 4a geschaltet. Im leitend geschalteten Zustand der Schalteinrichtung S₂ wird in dem Dämpfungsglied R₄ (in der Zeichnung fälschlicherweise auch R2 statt R4!) Leistung dissipiert, welche dem Parallelschwingkreis der sekundären Induktivität 4b und der Schallwandlereinrichtung 5 entzogen wird. Um eine Dämpfung mit Hilfe des Dämpfungsglieds R₄ zu erreichen, welche der Dämpfung durch das Dämpfungsglied R₄ der ersten Ausführungsform entspricht, ist das Übertragungsverhältnis N des Transformators 4 bestehend aus der primären Induktivität 4a und der sekundären Induktivität 4b zu berücksichtigen. Es ergibt hierbei ein Faktor von 1/N².

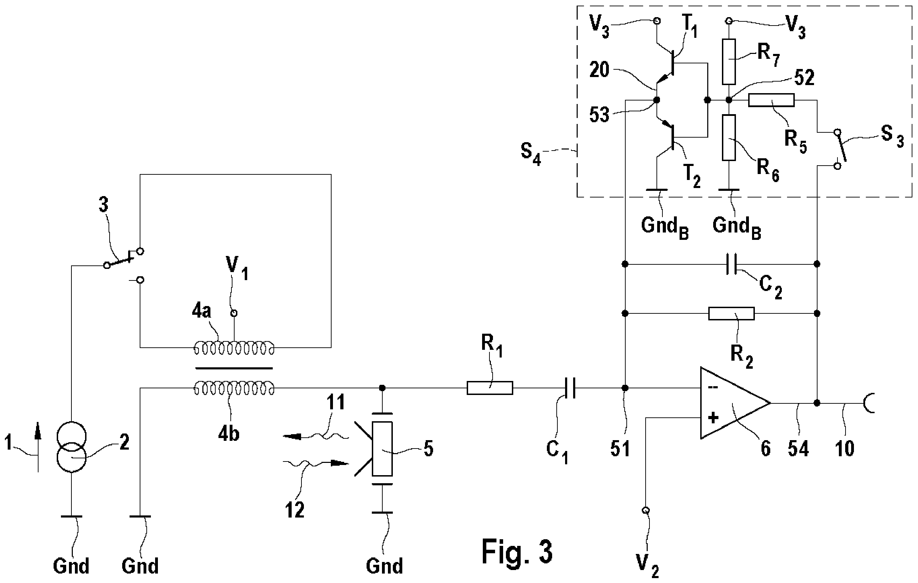

In Figur 3 ist eine Ausführungsform der vorliegenden Erfindung dargestellt. Ein erster Transistor T₁ ist mit dem Kollektor mit einem ersten Spannungspotential V₃ verbunden, welches z.B. das Versorgungsspannungspotential V_{DD} des Operationsverstärkers 6 sein kann. Der Transistor T₁ ist von einem ersten Leitfähigkeitstyp. Der Transistor T₁ kann ein bipolarer oder ein Feldeffekttransistor sein. Ein Transistor T₂ eines zweiten Leitfähigkeitstyps ist mit seinem Kollektor mit einem zweiten Massepotential Gnd_{B} verbunden, mit welchen eine Versorgungsleitung des Operationsverstärkers 6 verbunden sein kann. Die Emitter der beiden Transistoren T₁ und T₂ sind beide mit einem invertierenden Eingang des Operationsverstärkers 6 verbunden. Liegt an dem invertierenden Eingang des Operationsverstärkers 6 ein Signal an, dessen Potential um mindestens eine Schwellwertspannung des Transistor T₂ größer als das Potential ist, welches an der Basis des Transistors T₂ anliegt, schaltet der Transistor T₂ leitend und verbindet den invertierenden Eingang des Operationsverstärkers 6 mit dem zweiten Massenpotential Gnd_{B}. Analog schaltet der Transistor T₁ leitend, wenn das Potential einem invertierenden des Operationsverstärkers 6 um mindestens eine Schwellwertspannung des Transistors T₁ geringer ist als das Potential, welches an der Basis des Transistors T₁ anliegt. In diesem Fall wird der invertierende Eingang des Operationsverstärkers 6 mit dem ersten Spannungspotential V₃ verbunden. Der minimale Spannungsbetrag, welcher somit erforderlich ist, damit ein Strom durch das Dämpfungsglied R₁ zu dem Massepotential Gnd_{B} bzw. dem ersten Versorgungspotential V₃ abfließt, kann durch die Schwellwertspannung der Transistoren und dem Potential gesteuert werden, welches an der Basis der beiden Transistoren T₁ bzw. T₂ anliegt. Die beiden Basen der Transistoren sind mit dem Ausgangssignal des rückgekoppelten Operationsverstärkers 6 verbunden. Somit liegt an der Basis der Transistoren ein verstärktes invertiertes Eingangssignal an, welches an dem invertierenden Eingang des Operationsverstärkers 6 anliegt. Bei einem Signal von 50 mV am invertierenden Eingang des Operationsverstärkers und einer exemplarischen Verstärkung von 10 ergibt sich somit ein Basispotential von -500 mV an dem Transistor T₂. Ist die Schwellwertspannung des Transistors T₂ z. B. 550 mV, schaltet der Transistor T₂ in den leitenden Zustand. Analog schaltet der Transistor T₁ in den leitenden Zustand, wenn das Signal an dem invertierenden Eingang des Operationsverstärkers 6 -50mV beträgt. Daraus ergibt sich, dass ab einer Spannungsamplitude 50 mV ein Strom durch das Dämpfungsglied R₁ fließt und dann der Parallelschwingkreis mit der sekundären Induktivität 4b und der Schallwandlereinrichtung 5 gedämpft wird. Für Spannungsamplituden, welche geringer als 50 mV sind, wird eine Dämpfung durch die Rückkopplung durch den Operationsverstärker 6 erreicht. Hierbei kann der invertierende Eingang des Operationsverstärkers 6 als virtuelle Masse angesehen werden.

In dem Signalpfad zwischen der Basis der Transistoren T₁ und T₂ dem Ausgang des Operationsverstärker 6 kann eine Schalteinrichtung S₃ angeordnet sein. Dies ermöglicht die Dämpfung ein- bzw. abzuschalten.

Das Gleichspannungspotential des Operationsverstärkers 6 ist von dem Gleichspannungspotential des Parallelschwingkreises durch eine Kapazität C₁ entkoppelt.

Ein Verknüpfungspunkt 52 eines Spannungsteilers aus zwei Widerständen R₆ und R₇ ist mit der Basis der Transistoren T₁ und T₂ verbunden. Der Spannungsteiler verbindet die Versorgungsspannung V₃ mit dem Massepotential Gnd_{B}. Vorteilhafterweise sind die Widerstände R₆ und R₇ gleich groß gewählt.

In dem Signalpfad zwischen dem Ausgang des Operationsverstärkers 6 und dem Verknüpfungspunkt 52 ist ein zweiter Spannungsteiler durch einen Widerstande R₅ mit den Widerständen R₆ und R₇ gebildet. Dieser zweite Spannungsteiler ermöglicht eine Anpassung der Ausgangssignale des Operationsverstärkers 6 unabhängig von der gewählten Verstärkung der Operationsverstärkerschaltung bestehend aus dem Eingangswiderstand R₁, dem Rückkopplungswiderstand R₂ und dem Operationsverstärker 6.

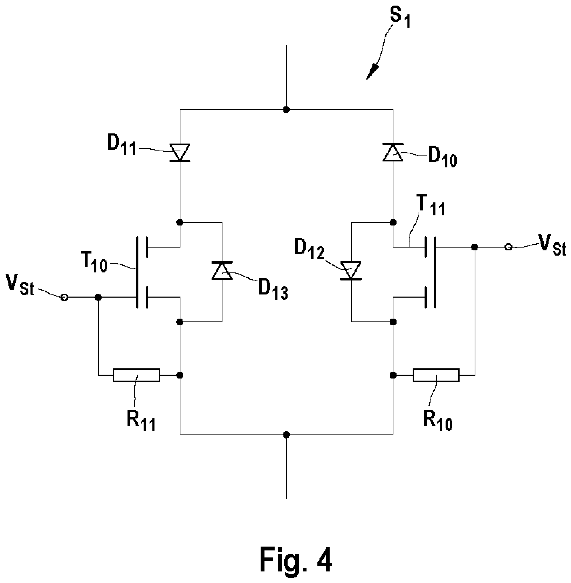

In Figur 4 ist eine schematische Darstellung einer Schalteinrichtung für eine der Ausführungsformen dargestellt. Die Schalteinrichtung besteht aus zwei antiparallel angeordneten miteinander auf beiden Seiten verbundenen Signalpfaden. Dabei weist ein Signalpfad eine Diode, einen Transistor, z. B. einen Feldeffekttransistor auf. An den Feldeffekttransistor kann ein externes Steuersignal V_{St} angelegt werden. Für eine erste Halbwelle ist der erste Signalpfad für eine zweite Halbwelle der zweite Signalpfad leitend geschaltet, wenn ein entsprechendes Steuersignal V_{St} an den beiden Transistoren T₁₀ und T₁₁ anliegt. Auf die Dioden D₁₀, D₁₁ kann verzichtet werden, wenn die Transistoren keine internen Schutzdioden D₁₂, D₁₃ aufweisen.

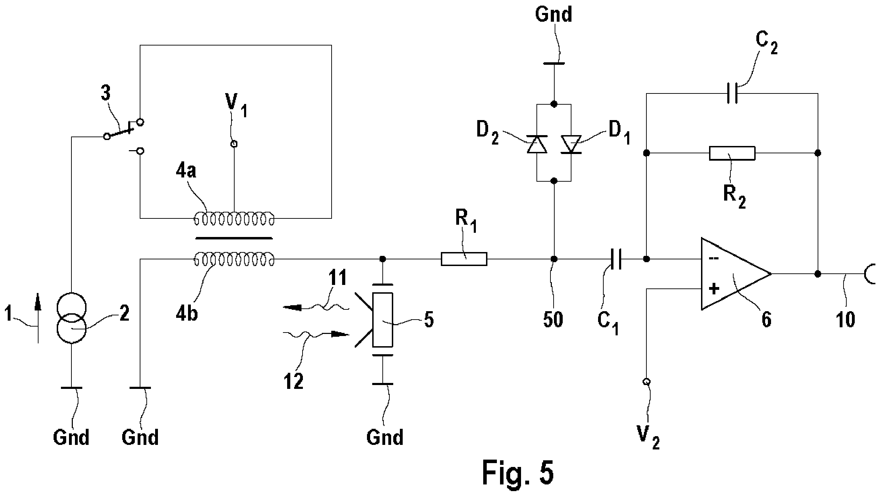

In Figur 5 ist eine dritte beispielhafte Ausführungsform schematisch dargestellt. Parallel zu der sekundären Induktivität 4b ist eine Reihenschaltung aus einem Dämpfungsglied R₁ und Parallelschaltung aus zwei antiparallel geschalteten Dioden D₁ und D₂ geschaltet. Vorzugsweise sind die beiden Dioden D₁ und D₂ Schottky-Dioden. Da diese eine sehr geringe Schwellspannung von typischerweise 0,2 Volt aufweisen, ergibt sich eine Dämpfung des Parallelschwingkreises für Signalamplituden, welche größer als 0,2 V sind. Eine Dämpfung für Signalamplituden, welche geringer als 0,2 V sind, kann durch den invertierenden Eingang des rückgekoppelten Operationsverstärkers 6 erreicht werden. Damit ergibt sich eine weitgehend lineare Dämpfung des Parallelschwingkreises mit der sekundären Induktivität 4b und der Schallwandlereinrichtung 5. Der erforderliche schaltungstechnische Aufwand durch die zwei zusätzlichen Schottky-Dioden ist vorteilhafterweise sehr gering. Dies ermöglicht somit eine kostengünstige Variante für eine verbesserte Dämpfung des Parallelschwingkreises. Diese Bedämpfung ist allerdings auch, da nicht geschaltet, während des Sendevorgangs wirksam.

Obwohl die vorliegende Erfindung anhand eines bevorzugten Ausführungsbeispiels vorstehend beschrieben wurde, ist sie darauf nicht beschränkt sondern auf vielfältige Weise innerhalb des Rahmens der angehängten Ansprüche modifizierbar. Hierbei kann an Stelle der Schallwandlereinrichtung 5 ebenso eine andere resonant angetriebene kapazitative Einrichtung angeordnet sein, welche resonant angeregt wird und in möglichst kurzer Zeit stark gedämpft werden soll. Hierbei wird unter anderem an Sensoren für Sonarmessungen gedacht.

## Patentansprüche

1. Vorrichtung zur Dämpfung eines Parallelschwingkreises mit einem Parallelschwingkreis mit einer sekundären Induktivität (4b) und einer ersten Kapazität (5), wobei in die sekundäre Induktivität (4b) über eine primäre Induktivität (4a) ein Signal (1) induktiv einkoppelbar ist; wobei der sekundären Induktivität ein Dämpfungsglied (R1) mit einer Schalteinrichtung (S4) parallel geschaltet angeordnet ist, **dadurch gekennzeichnet, dass** ein Verknüpfungspunkt (51) zwischen dem Parallelschwingkreis und der Schalteinrichtung (S4) mit einem invertierenden Eingang eines Operationsverstärkers (6) verbunden ist; wobei in der Schalteinrichtung (S4) ein erster Transistor (T1) zwischen dem Verknüpfungspunkt (51) und einem ersten Potential (V3) angeordnet ist und ein zweiter Transistor (T2) zwischen dem Verknüpfungspunkt (51) und einem ersten Massepotential (GndB) angeordnet ist; und wobei die Steuereingänge der beiden Transistoren (T1, T2) mit einem Signalausgang des Operationsverstärkers (6) verbunden sind.

2. Vorrichtung nach Anspruch 1, wobei die Schalteinrichtung (S4) mittels eines externen Schaltsignals (VSt) schaltbar ist.

3. Vorrichtung nach mindestens einem der Ansprüche 1 oder 2, wobei die primäre Induktivität (4a) mit einer Stromquelle (2) über ein Schaltelement (3) verbunden ist.

4. Vorrichtung nach einem der vorhergehenden Ansprüche, wobei der Parallelschwingkreis über das Dämpfungsglied (R1) und einen Kondensator (C1) mit einem invertierenden Eingang des Operationsverstärkers (6) verbunden ist.

5. Vorrichtung nach einem der vorhergehenden Ansprüche, wobei zwischen den Steuereingängen der beiden Transistoren (T1, T2) und dem Signalausgang (54) des Operationsverstärkers (6) eine weitere Schalteinrichtung (S3) angeordnet ist.

6. Vorrichtung nach mindestens einem der Ansprüche 1 bis 4, wobei zwischen den Steuereingängen der beiden Transistoren (T1, T2) und dem Signalausgang (54) des Operationsverstärkers (6) ein Spannungsteiler (R5, R6) angeordnet ist.

7. Vorrichtung nach mindestens einem der vorhergehenden Ansprüche, wobei die Kapazität (5) die Kapazität einer Schallwandlereinrichtung (5) ist.

8. Vorrichtung nach mindestens einem der vorhergehenden Ansprüche, wobei die weitere Schalteinrichtung (S3) Transistoren (T10, T11) aufweisen.

9. Vorrichtung nach Anspruch 1, wobei die weitere Schalteinrichtung (S3) eine passive Schalteinrichtung (D10, D11) aufweist.

10. Vorrichtung nach Anspruch 9, wobei die passive Schalteinrichtung (D10, D11) zwei antigeschaltete Dioden aufweist, welche in Serie zu dem Dämpfungsglied (R1) geschaltet sind.

11. Vorrichtung nach mindestens einem der Ansprüche 9 oder 10, wobei das Dämpfungsglied (R1) einen Widerstand (R1) und Schottkydioden (D10, D11) aufweist.

12. Verfahren zum Dämpfen eines Parallelschwingkreises (4b, 5), welcher eine sekundäre Induktivität (4b) und eine erste Kapazität (5) aufweist, wobei in die sekundäre Induktivität (4b) über eine primäre Induktivität (4a) ein Signal (1) induktiv eingekoppelt wird; und wobei parallel zur primären (4a) und/oder zur sekundären Induktivität ein Serienschaltkreis aus einem Dämpfungsglied (R1) und einer Schalteinrichtung (S4) angeordnet ist und wobei ein Verknüpfungspunkt (51) zwischen dem Parallelschwingkreis und der Schalteinrichtung (S1; S4, D1, D2) mit einem invertierenden Eingang eines Operationsverstärkers (6) verbunden ist; und wobei in der Schalteinrichtung (S4) ein erster Transistor (T1) zwischen dem Verknüpfungspunkt (51) und einem ersten Potential (V3) angeordnet ist und ein zweiter Transistor (T2) zwischen dem Verknüpfungspunkt (51) und einem ersten Massepotential (GndB) angeordnet ist; und wobei die Steuereingänge der beiden Transistoren (T1, T2) mit einem Signalausgang des Operationsverstärkers (6) verbunden sind mit den Schritten:
Schalten der Schalteinrichtung (S4) in einen leitenden Zustand, wenn das Signal (1) gedämpft werden soll.

## Claims

1. Apparatus for attenuating a parallel resonant circuit, having a parallel resonant circuit having a secondary inductance (4b) and a first capacitance (5), wherein a signal (1) can be inductively coupled into the secondary inductance (4b) via a primary inductance (4a); wherein an attenuation element (R1) having a switching device (S4) is arranged connected in parallel with the secondary inductance, **characterized in that** a link point (51) between the parallel resonant circuit and the switching device (S4) is connected to an inverting input of an operational amplifier (6); wherein, in the switching device (S4), a first transistor (T1) is arranged between the link point (51) and a first potential (V3) and a second transistor (T2) is arranged between the link point (51) and a first earth potential (GndB); and wherein the control inputs of the two transistors (T1, T2) are connected to a signal output of the operational amplifier (6).

2. Apparatus according to Claim 1, wherein the switching device (S4) can be switched by means of an external switching signal (VSt).

3. Apparatus according to at least either of Claims 1 and 2, wherein the primary inductance (4a) is connected to a current source (2) by means of a switching element (3).

4. Apparatus according to any of the preceding claims, wherein the parallel resonant circuit is connected to an inverting input of the operational amplifier (6) by means of the attenuation element (R1) and a capacitor (C1).

5. Apparatus according to any of the preceding claims, wherein a further switching device (S3) is arranged between the control inputs of the two transistors (T1, T2) and the signal output (54) of the operational amplifier (6).

6. Apparatus according to at least one of Claims 1 to 4, wherein a voltage divider (R5, R6) is arranged between the control inputs of the two transistors (T1, T2) and the signal output (54) of the operational amplifier (6).

7. Apparatus according to at least one of the preceding claims, wherein the capacitance (5) is the capacitance of an acoustic transducer device (5).

8. Apparatus according to at least one of the preceding claims, wherein the further switching device (S3) has transistors (T10, T11).

9. Apparatus according to Claim 1, wherein the further switching device (S3) has a passive switching device (D10, D11).

10. Apparatus according to Claim 9, wherein the passive switching device (D10, D11) has two reverse-connected diodes, which are connected in series with the attenuation element (R1).

11. Apparatus according to at least either of Claims 9 and 10, wherein the attenuation element (R1) has a resistor (R1) and Schottky diodes (D10, D11).

12. Method for attenuating a parallel resonant circuit (4b, 5), which has a secondary inductance (4b) and a first capacitance (5), wherein a signal (1) is inductively coupled into the secondary inductance (4b) via a primary inductance (4a); and wherein a series circuit composed of an attenuation element (R1) and a switching device (S4) is arranged in parallel with the primary (4a) and/or with the secondary inductance and wherein a link point (51) between the parallel resonant circuit and the switching device (S1; S4, D1, D2) is connected to an inverting input of an operational amplifier (6); and wherein, in the switching device (S4), a first transistor (T1) is arranged between the link point (51) and a first potential (V3) and a second transistor (T2) is arranged between the link point (51) and a first earth potential (GndB); and wherein the control inputs of the two transistors (T1, T2) are connected to a signal output of the operational amplifier (6),
said method having the following steps:
switching the switching device (S4) to a conducting state when the signal (1) is intended to be attenuated.

## Revendications

1. Ensemble d'amortissement d'un circuit oscillant parallèle,
l'ensemble présentant un circuit oscillant parallèle doté d'une inductance secondaire (4b) et d'une première capacité (5),
un signal (1) pouvant être injecté par induction dans l'inductance secondaire (4b) par l'intermédiaire d'une inductance primaire (4a),
un organe d'amortissement (R1) présentant un circuit (S4) étant raccordé en parallèle à l'inductance secondaire,
**caractérisé en ce que**
un point de combinaison (51) entre le circuit oscillant parallèle et le circuit (S4) est relié à une entrée inversante d'un amplificateur opérationnel (6),
**en ce qu'**un premier transistor (T1) est disposé dans le circuit (S4) entre le point de combinaison (51) et un premier potentiel (V3) et un deuxième transistor (T2) est disposé entre le point de combinaison (51) et un premier potentiel de masse (GndB) et
**en ce que** les entrées de commande des deux transistors (T1, T2) sont reliées à la sortie de signal de l'amplificateur opérationnel (6).

2. Ensemble selon la revendication 1, dans lequel le circuit (S4) peut être commuté au moyen d'un signal de commutation externe (VSt).

3. Ensemble selon au moins l'une des revendications 1 ou 2, dans lequel l'inductance primaire (4a) est reliée à une source de courant (2) par l'intermédiaire d'un élément de commutation (3).

4. Ensemble selon l'une des revendications précédentes, dans lequel le circuit oscillant parallèle est relié par l'intermédiaire de l'organe d'amortissement (R1) et d'un condensateur (C1) à une entrée inversante de l'amplificateur opérationnel (6).

5. Ensemble selon l'une des revendications précédentes, dans lequel un autre circuit (S3) est disposé entre les entrées de commande des deux transistors (T1, T2) et la sortie de signal (54) de l'amplificateur opérationnel (6).

6. Ensemble selon au moins l'une des revendications 1 à 4, dans lequel un diviseur de tension (R5, R6) est disposé entre les entrées de commande des deux transistors (T1, T2) et la sortie de signal (54) de l'amplificateur opérationnel (6).

7. Ensemble selon au moins l'une des revendications précédentes, dans lequel la capacité (5) est la capacité d'un dispositif (5) de conversion acoustique.

8. Ensemble selon au moins l'une des revendications précédentes, dans lequel l'autre circuit (S3) présente des transistors (T10, T11).

9. Ensemble selon la revendication 1, dans lequel l'autre circuit (S3) présente un circuit passif (D1, D11).

10. Ensemble selon la revendication 9, dans lequel le circuit passif (D10, D11) présente deux diodes raccordées en opposition et raccordées en série à l'organe d'amortissement (R1).

11. Ensemble selon au moins l'une des revendications 9 ou 10, dans lequel l'organe d'amortissement (R1) présente une résistance (R1) et des diodes Schottky (D10, D11).

12. Procédé d'amortissement d'un circuit oscillant parallèle (4b, 5) qui présente une inductance secondaire (4b) et une première capacité (5),
un signal (1) pouvant être injecté par induction dans l'inductance secondaire (4b) par l'intermédiaire d'une inductance primaire (4a),
un circuit série formé d'un organe d'amortissement (R1) et d'un circuit (S4) étant raccordé en parallèle à l'inductance primaire (4a) et/ou à l'inductance secondaire,
un point de combinaison (51) entre le circuit oscillant parallèle et le circuit (S4) étant relié à une entrée inversante d'un amplificateur opérationnel (6),
un premier transistor (T1) étant disposé dans le circuit (S4) entre le point de combinaison (51) et un premier potentiel (V3) et un deuxième transistor (T2) étant disposé entre le point de combinaison (51) et un premier potentiel de masse (GndB) et
les entrées de commande des deux transistors (T1, T2) étant reliées à la sortie de signal de l'amplificateur opérationnel (6),
le procédé présentant l'étape qui consiste à commuter le circuit (S4) à l'état conducteur lorsque le signal (1) doit être amorti.
